# DEMANDE DE BREVET EUROPEEN

(11) **EP 0 597 752 A1**
(43) Date de publication de la demande: **18.05.1994**
(21) Numéro de dépôt: 93402653.5
(22) Date de dépôt: 28.10.1993
(51) Int. Cl.: G01R 33/035

(54) **Dispositif de mesure d'un champ magnétique**

(30) Priorité: 13.11.1992 FR 9213692
(71) Demandeur: FRAMATOME, 92400 Courbevoie (FR); CENTRE NATIONAL DE LA RECHERCHE SCIENTIFIQUE (CNRS), 75700 Paris Cedex 07 (FR)
(72) Inventeur: Chaussy, Jacques, F-38130 Echirolles (FR); Ayela, Frédéric, F-38000 Grenoble (FR); Bret, Jean-Louis, F-38180 Seyssins (FR)
(74) Mandataire: Habasque, Etienne Joel Jean-François

(57) **Abrégé**

Ce dispositif, comportant un premier corps (1) en matériau supraconducteur placé dans le champ magnétique à mesurer, des moyens (7) adaptés pour faire passer successivement la température de ce corps au-dessus et au-dessous de sa température de transition, à une première fréquence, de manière à engendrer des variations de champ dans le voisinage du corps, et des moyens de détermination du champ à partir de ces variations, est caractérisé en ce que ces moyens comportent un second corps (4) en matériau supraconducteur, placé au voisinage du premier corps (1), des moyens (8) adaptés pour faire passer la température d'au moins une portion de ce second corps, au-dessus et au-dessous de sa température de transition, à une seconde fréquence supérieure à la première, pour engendrer dans ce corps, des variations de courant proportionnelles aux variations de champ, des moyens (10) de mesure de ces variations de courant et des moyens de détermination du champ à partir de ces variations.

## Description

La présente invention concerne un dispositif de mesure d'un champ magnétique à l'aide de corps en matériau supraconducteur placés dans le champ magnétique à mesurer et permettant de réaliser une mesure absolue d'un très faible champ magnétique.

On connaît déjà dans l'état de la technique un certain nombre de dispositifs de ce type comme, par exemple, des interféromètres quantiques supraconducteurs (Superconducting Quantum Interference Device "SQUID"). Le fonctionnement de ces interféromètres est basé sur des phénomènes liés à la supraconductivité des matériaux utilisés, comme la quantification du flux magnétique et les effets JOSEPHSON.

En effet, si on refroidit un anneau de matériau métallique jusqu'au passage de celui-ci à l'état supraconducteur, en présence d'un champ magnétique, puis que l'on coupe ce champ, on note que le flux magnétique, quantité représentant le produit du champ dans l'anneau par la surface de ce dernier, reste piégé dans l'anneau. Le flux est en effet maintenu par un courant de supraconduction qui a pris naissance dans l'anneau pour s'opposer aux variations de flux, d'après la loi de LENZ, et y persiste de façon permanente. Ainsi, le courant induit dans l'anneau est une représentation du flux et donc du champ magnétique que l'on désire déterminer. La mesure de ce courant permet donc de déduire le champ magnétique. Cependant, cette mesure présente un certain nombre d'inconvénients.

En effet, dans un interféromètre dit à effet JOSEPHSON continu l'anneau supraconducteur comporte deux barrières. Par application d'un champ magnétique, celles-ci deviennent résistives et il apparaît une différence de potentiel entre les parties de l'anneau séparées par les barrières. La différence de potentiel est alors mesurable et permet de déterminer le flux magnétique.

Dans les interféromètres dits à effet JOSEPHSON alternatif, l'anneau ne présente qu'une seule barrière et est de ce fait plus facile à fabriquer. Cependant, il est plus difficile de détecter le passage à l'état résistif d'une barrière et ce problème est résolu en mettant à profit la faible inductance de l'anneau. Celui-ci est en effet couplé par induction mutuelle à un circuit oscillant extérieur qui y induit un courant alternatif à des fréquences allant d'une dizaine de MHz jusqu'aux hyperfréquences. Les variations du courant dans l'anneau, induites par le champ magnétique à mesurer, se traduisent alors par des variations du niveau d'oscillation du circuit extérieur, variations que l'on peut mesurer pour déterminer le champ magnétique.

On conçoit que ce type d'interféromètres quantiques supraconducteurs utilisant l'effet JOSEPHSON ne permettent de détecter que des variations de flux magnétique. Ces dispositifs très performants exigent, pour les élaborer, la maîtrise de techniques très évoluées et par là-même très onéreuses. En effet, leur fabrication est extrêmement délicate dans la mesure où il est nécessaire de réaliser des jonctions tunnels constituant les barrières décrites précédemment et d'utiliser une électronique de mesure associée très complexe.

Pour plus de renseignements sur ces interféromètres, on se reportera aux articles publiés dans les revues "La Recherche" n° 133, Mai 1982, pages 604 à 613 et "Pour la Science" n° 138, Avril 1989, pages 52 à 61.

On connaît également, par exemple du document US-A-3.437.919, un magnétomètre cryogénique. Ce magnétomètre comprend une bobine de détection disposée entre deux disques en matériau supraconducteur. Les disques sont maintenus à une température inférieure à 10°K dans un cryostat rempli d'hélium liquide.

La température des disques est périodiquement et simultanément modifiée de façon qu'elle soit alternativement inférieure et supérieure à leur température de transition supraconductrice.

De ce fait, le flux magnétique à mesurer passe au travers des disques et de la bobine de détection à la même fréquence que les changements de température des disques.

On connaît également du document FR-A-2.648.568 un magnétomètre dans lequel on chauffe une couche mince en matériau supraconducteur se présentant par exemple sous la forme d'un disque, à l'aide d'un rayonnement lumineux transmis par une fibre optique. La couche mince de matériau supraconducteur passe alors alternativement au-dessus et au-dessous de sa température de transition supraconductrice, ce qui permet de laisser passer les lignes de flux de champ magnétique à mesurer. Une bobine de mesure est disposée autour de la couche mince de façon à détecter les variations de champ magnétique.

Cependant, l'application de ces dispositifs à la détection et à la mesure de très faibles champs magnétiques, nécessite des cycles complets de transition thermique à haute fréquence sur la totalité de la surface des disques. On conçoit alors qu'une très grosse difficulté apparaît, cette difficulté consistant à ne pas bloquer les lignes de champ dans un disque lorsque celui-ci se refroidit au-dessous de sa température de transition supraconductrice.

Pour éviter ce blocage, il est nécessaire que le refroidissement s'effectue régulièrement du centre du disque jusqu'à sa périphérie.

Cependant, le contrôle de cette régulation limite la fréquence de modulation thermique et donc la sensibilité du dispositif.

Le but de l'invention est donc de résoudre ces problèmes.

A cet effet, l'invention a pour objet un dispositif de mesure d'un champ magnétique, du type comportant un premier corps en matériau supraconducteur placé dans le champ magnétique à mesurer, des moyens adaptés pour faire passer successivement la température de ce premier corps en matériau supraconducteur au-dessus et au-dessous de sa température de transition supraconductrice, à une première fréquence, et donc faire passer ce premier corps d'un premier état dans lequel il est perméable aux lignes de champ, lorsque sa température est supérieure à sa température de transition supraconductrice, dans un second état dans lequel il est imperméable aux lignes de champ, lorsque sa température est inférieure à sa température de transition supraconductrice, et inversement, de manière à engendrer des variations de champ magnétique dans le voisinage du corps, et des moyens de détection de ces variations de champ et de détermination du champ à partir de ces variations, caractérisé en ce que les moyens de détection et de détermination comportent un second corps en matériau supraconducteur, placé dans le champ magnétique à mesurer, au voisinage du premier corps, des moyens adaptés pour faire passer la température d'au moins une portion de ce second corps en matériau supraconducteur, au-dessus et au-dessous de sa température de transition supraconductrice, à une seconde fréquence supérieure à la première, pour engendrer dans ce second corps, des variations de courant proportionnelles aux variations de champ induites par le premier corps, des moyens de mesure de ces variations de courant pour déterminer les variations de champ correspondantes et des moyens de détermination du champ à partir de ces variations.

Avantageusement, les moyens de détermination du champ sont reliés à des moyens de génération d'un champ opposé au champ déterminé pour réaliser une réinitialisation du dispositif à la seconde fréquence et permettre une détermination de la valeur absolue du champ.

L'invention sera mieux comprise à l'aide de la description qui va suivre, donnée uniquement à titre d'exemple et faite en se référant aux dessins annexés sur lesquels :
- La figure 1 représente une vue schématique en coupe d'un dispositif de mesure selon l'invention ;
- La figure 2 représente une vue de détail à échelle agrandie d'une partie du dispositif de mesure représenté sur la figure 1 ;
- Les figures 3 et 4 illustrent le principe de fonctionnement d'un dispositif de mesure selon l'invention ;
- La figure 5 illustre l'implantation des différents composants d'un dispositif de mesure selon l'invention dans un cryostat, et
- Les figures 6A et 6B représentent des formes de signaux en différents points d'un dispositif selon l'invention.

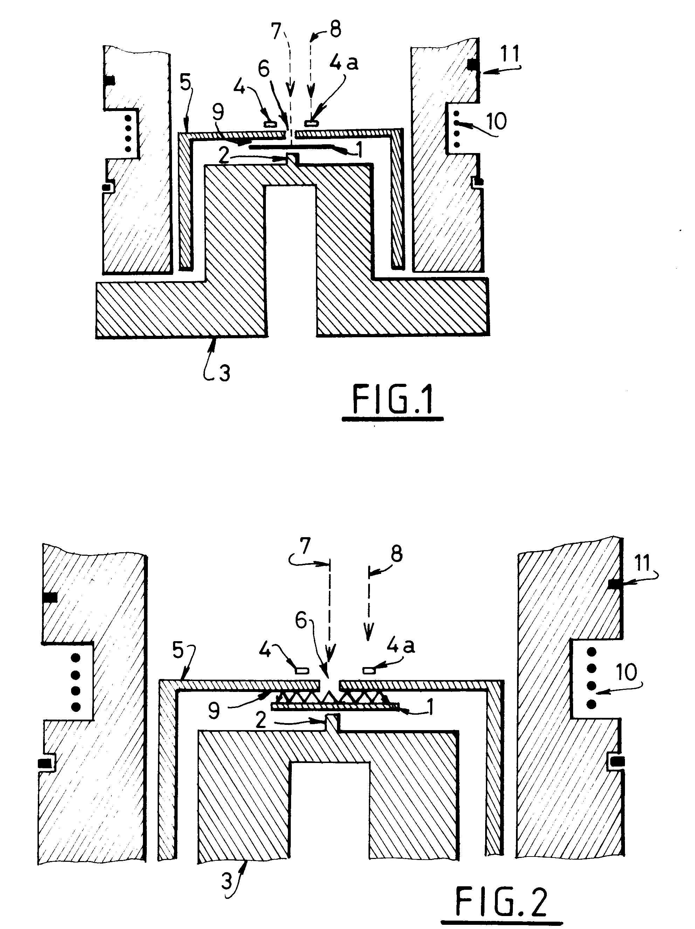

Ainsi qu'on peut le voir sur les figures 1 et 2, un dispositif de mesure d'un champ magnétique selon l'invention, comporte un premier corps en matériau supraconducteur placé dans le champ magnétique à mesurer. Ce corps se présente par exemple sous la forme d'un disque désigné par la référence générale 1 sur ces figures et ce disque est disposé sur un plot de support 2 d'une embase désignée par la référence générale 3.

Ce premier corps en matériau supraconducteur est associé à des moyens adaptés pour faire passer successivement la température de celui-ci au-dessus et au-dessous de sa température de transition supraconductrice, à une première fréquence, et donc faire passer ce premier corps d'un premier état dans lequel il est perméable aux lignes de champ, lorsque sa température est supérieure à sa température de transition supraconductrice, dans un second état dans lequel il est imperméable aux lignes de champ, lorsque sa température est inférieure à sa température de transition supraconductrice et inversement.

Comme celà a été décrit dans le document FR-A-2.648.568 mentionné précédemment, ceci permet d'engendrer des variations de champ magnétique dans le voisinage du corps. Des moyens de détection de ces variations de champ et de détermination du champ à partir de ces variations sont prévus au voisinage de ce premier corps et ces moyens de détection et de détermination comportent un second corps en matériau supraconducteur désigné par la référence générale 4 sur ces figures.

Ce second corps se présente avantageusement sous la forme d'un anneau de matériau supraconducteur par exemple identique à celui dont est. constitué le disque 1 et dont le diamètre est inférieur à celui du disque. Cet anneau est avantageusement réalisé par dépôt de matériau sur une structure de support 5 disposée au-dessus de l'embase 3, cet anneau étant prévu sur la face de cette structure de support 5 opposée à celle en regard du disque 1 et disposé symétriquement autour d'un orifice 6 de cette structure de support. La partie centrale du disque 1 est également située en regard de cet orifice. La fonction de cet orifice sera décrite plus en détail par la suite.

On notera que la structure de support 5 et l'embase 3 sont réalisées en matériau isolant électriquement, par exemple en céramique, permettant de maintenir le disque et l'anneau en position relative l'un par rapport à l'autre et faisant office d'éléments thermiques de façon à ne pas introduire de constante de temps trop importante pour chauffer ou refroidir par exemple le disque.

Par ailleurs, le fait de prévoir des éléments de support séparés pour le disque et l'anneau permet de réaliser un découplage des températures de ces deux organes.

Ces premier et second corps sont disposés dans un cryostat qui sera décrit plus en détail par la suite, à une température inférieure à leur température de transition supraconductrice et il est prévu des moyens de chauffage d'au moins une portion de ces corps.

Les moyens de chauffage de chaque corps comprennent avantageusement des moyens de génération d'un rayonnement optique disposés chacun à une extrémité d'un guide optique, à l'extérieur du cryostat, l'autre extrémité de chaque guide étant disposé en regard du corps correspondant dans le cryostat, comme celà est illustré par les références 7 et 8 sur ces figures 1 et 2. On conçoit que le guide optique, par exemple 7, associé au disque 1 et constitué par exemple par au moins une fibre optique, présente une extrémité en regard de la partie centrale du disque située en regard de l'orifice 6 de la structure de support 5, pour chauffer ce disque.

A cet égard on notera que la surface de la face de la structure de support 5 en regard du disque peut être réfléchissante, comme cela est illustré par la référence 9 sur cette figure.

Cette face est alors traitée de façon à ce que la cavité formée entre ce disque et cette face se comporte comme un corps noir. La surface correspondante du disque peut également être polie de façon à ce que le faisceau optique délivré par le guide optique 7 et qui traverse l'orifice 6, soit réfléchi par le disque 1 et la face 9 correspondante de la structure de support, pour obtenir une bonne répartition de ce faisceau sur toute la surface du disque.

Le guide optique 8 est quant à lui destiné à permettre un chauffage d'une zone 4a de l'anneau 4 à une fréquence plus élevée que celle utilisée pour le disque.

On conçoit alors que cette association de moyens de chauffage périodique du disque et d'une zone de l'anneau, permet d'engendrer dans le voisinage du disque des variations de champ magnétique qui se traduisent par des variations de courant proportionnelles à ces variations de champ induites par le premier corps, c'est-à-dire par le disque, dans le second corps c'est-à-dire dans l'anneau.

Des moyens 10 de mesure de ces variations de courant sont associés à cet anneau pour déterminer les variations de champ magnétique correspondantes et permettre la détermination du champ à partir des mesures délivrées par ces moyens.

Avantageusement, ces moyens de mesure associés à cet anneau comprennent une bobine formée d'au moins une spire de matériau supraconducteur disposée autour de l'anneau.

En fait, cette bobine de mesure peut être intégrée dans un circuit résonnant dans lequel un condensateur est connecté aux bornes de cette bobine, la fréquence de résonance de ce circuit résonnant étant égale à la seconde fréquence, c'est-à-dire à la fréquence de commutation de la température de la zone 4a de l'anneau au-dessus et au-dessous de sa température de transition supraconductrice et permettant de déterminer le champ par mesure de la tension aux bornes de cette bobine.

Enfin, ces moyens de détermination du champ peuvent être reliés à des moyens 11 de génération d'un champ opposé au champ déterminé pour réaliser une réinitialisation du dispositif à la seconde fréquence et permettre une détermination de la valeur absolue du champ.

Ces moyens de génération comprennent par exemple au moins une bobine de Helmholtz raccordée à des moyens d'alimentation de type classique pilotés par les moyens de détermination et dont la tension de sortie est une image du champ magnétique déterminé.

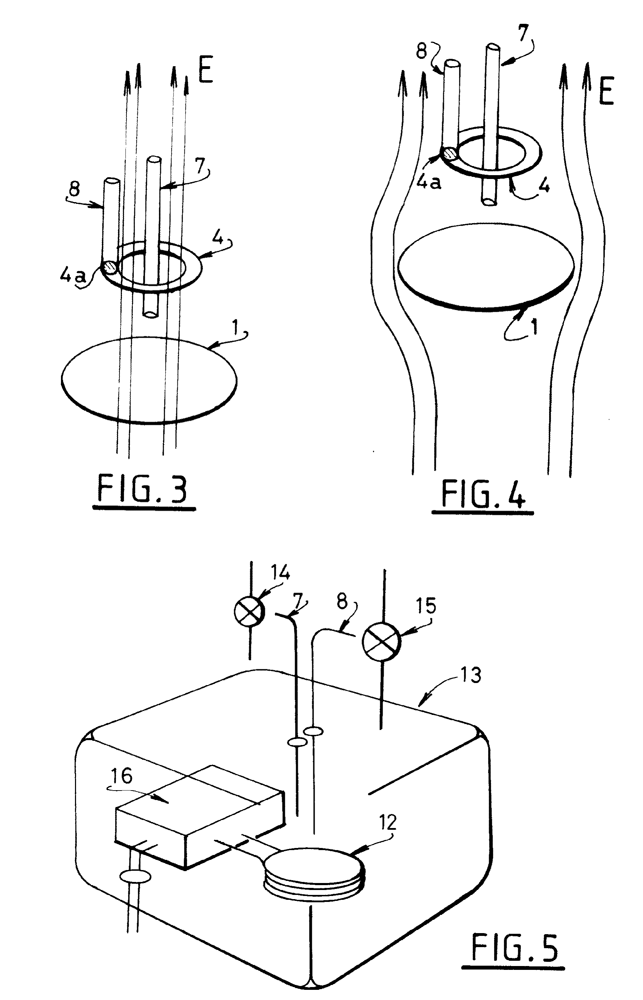

On a illustré sur les figures 3 et 4 le principe de fonctionnement du dispositif de mesure selon l'invention.

Comme on peut le voir sur ces figures, tant que la température du disque 1 et de la zone 4a de l'anneau 4 est supérieure à la valeur critique, c'est-à-dire à la température de transition supraconductrice, le dispositif est dans un premier état dans lequel il est perméable aux lignes de champ E. Si la puissance optique délivrée par la fibre 7 diminue, c'est-à-dire si la puissance de chauffage diminue, de façon que le disque 1 soit entièrement supraconducteur, ce corps devient imperméable aux lignes de champ magnétique, comme celà est illustré sur la figure 4. L'anneau 4 dont la zone 4a est restée normale lors du refroidissement du disque 1, se situe alors dans un trou de champ.

La modulation thermique alternative haute fréquence de cette zone de part et d'autre de sa valeur critique grâce au faisceau émis par la fibre optique 8, n'induit aucun signal.

Si l'on chauffe progressivement le disque 1 grâce au faisceau délivré par la fibre 7 tout en faisant transiter la température de la zone 4a de l'anneau 4 par exemple à une fréquence de l'ordre de 100 kHz, au-dessus et au-dessous de sa température de transition, lorsque la température du disque approche de sa valeur critique, un tourbillon magnétique va traverser ce disque. Cette variation de flux, se développant sur un temps supérieur à la période de transition de la zone 4a de l'anneau 4, va induire dans celui-ci une brusque variation de courant qui est détectée par la bobine de détection 10.

Ce processus se répète pendant la suite du chauffage du disque 1 jusqu'à ce que toutes les lignes de champ magnétique E soient revenues dans un état initial.

On conçoit alors que la bobine de mesure 10 permet de déterminer le champ magnétique dans lequel sont placés ces corps par mesure des variations de courant circulant dans l'anneau, ces variations étant proportionnelles aux variations de champ induites par le disque.

Cette bobine de mesure peut être raccordée à tout moyen d'alimentation de type classique dont la sortie est reliée aux bobines de Helmholtz 11 décrites précédemment, pour engendrer un champ magnétique d'amplitude égale au nombre de quanta de flux détectés lors de la phase de chauffage du disque 1, mais de signe opposé, pour obtenir une réinitialisation du dispositif à la seconde fréquence et permettre une détermination de la valeur absolue du champ.

En effet, le disque 1 restant dans sa phase normale, le flux résiduel traversant l'anneau 4 a une valeur inférieure au flux initial Φ 0 et la commutation haute fréquence de la température de la zone 4a de l'anneau 4 fournit un signal proportionnel au champ résiduel, qui peut être annulé grâce aux bobines de Helmholtz 11.

On conçoit alors que la connaissance de la tension appliquée à ces bobines permet de déterminer une valeur absolue du champ.

Comme on peut le voir sur la figure 5, cet ensemble de mesure désigné de façon générale par la référence 12 sur cette figure peut être disposé dans un cryostat 13 à une température inférieure à la température de transition supraconductrice des éléments de cet ensemble. Des extrémités des fibres optiques 7 et 8 sont associées à des moyens de génération d'un rayonnement optique désignés par les références 14 et 15 respectivement.

Ces moyens de génération disposés à l'extérieur du cryostat peuvent être constitués par exemple par des diodes laser ou des diodes électroluminescentes.

La tension engendrée aux bornes de la bobine de détection 10, lors de la mesure des variations de champ, peut être mesurée par tout dispositif de mesure approprié 16 et qui peut être formé par exemple par le dispositif décrit dans la demande de brevet français FR-92-00083 déposée le 7 janvier 1992 par les Demanderesses.

Ces moyens de mesure 16 peuvent également être disposés dans le cryostat 13 à une température inférieure à la température de transition supraconductrice des deux corps mentionnés précédemment, par exemple à 4°K ou plus en fonction des matériaux supraconducteurs utilisés.

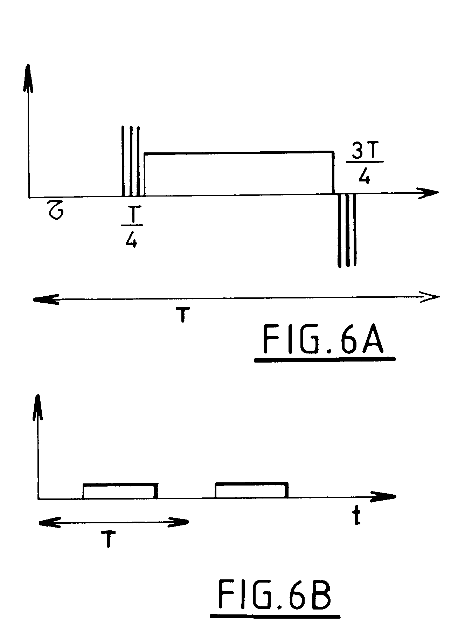

Enfin, on a représenté sur la figure 6A la courbe de réponse d'un dispositif selon l'invention où sont représentées en abscisse l'échelle des temps et en ordonnée l'amplitude du courant alternatif induit par exemple dans la bobine de détection 10.

Le temps T (figure 6B) par exemple de 10 millisecondes représente un cycle de chauffage et de refroidissement du disque 1 en matériau supraconducteur.

Au temps T = 0, celui-ci est dans un état supra-conducteur.

Au temps T = T/4 - ε, la température du disque se rapproche de sa valeur critique et les premières lignes de champ apparaissent sous la forme d'un Vortex.

Chaque passage de ligne est détecté par l'anneau 4 dont la température de la zone 4a passe au-dessus et au-dessous de sa température de transition à une période τ, par exemple de 10 microsecondes, et se traduit par une impulsion de courant dans cette bobine (figure 6A).

On a décrit précédemment le fonctionnement global du dispositif sur une demi-période de modulation du disque 1, mais en pratique il est possible que la réalisation de la contre-réaction en champ magnétique ne puisse s'effectuer aussi brièvement.

Dans ce cas, lors du refroidissement du disque 1, les lignes de flux restantes sont progressivement expulsées du disque 1 et détectées par l'anneau 4.

Il est possible de recommencer le cycle de modulation thermique de ce disque autant de fois que nécessaire jusqu'à ce que le champ résiduel soit suffisamment faible pour laisser le disque 1 dans l'état normal et ne faire transiter que la température de la zone 4a de l'anneau 4.

Le disque 1 a alors un rôle de réinitialisation du dispositif.

Enfin, on notera que la première fréquence de modulation thermique du disque peut par exemple être de l'ordre de 100 Hz tandis que la seconde associée à l'anneau peut être de l'ordre de 100 kHz.

## Revendications

**1.** Dispositif de mesure d'un champ magnétique, du type comportant un premier corps (1) en matériau supraconducteur placé dans le champ magnétique à mesurer, des moyens (7, 14) adaptés pour faire passer successivement la température de ce premier corps en matériau supraconducteur au-dessus et au-dessous de sa température de transition supraconductrice, à une première fréquence, et donc faire passer ce premier corps (1) d'un premier état dans lequel il est perméable aux lignes de champ, lorsque sa température est supérieure à sa température de transition supraconductrice, dans un second état dans lequel il est imperméable aux lignes de champ, lorsque sa température est inférieure à sa température de transition supraconductrice, et inversement, de manière à engendrer des variations de champ magnétique dans le voisinage du corps, et des moyens de détection de ces variations de champ et de détermination du champ à partir de ces variations, caractérisé en ce que les moyens de détection et de détermination comportent un second corps (4) en matériau supraconducteur, placé dans le champ magnétique à mesurer, au voisinage du premier corps (1), des moyens (8, 15) adaptés pour faire passer la température d'au moins une portion (4a) de ce second corps en matériau supraconducteur, au-dessus et au-dessous de sa température de transition supraconductrice, à une seconde fréquence supérieure à la première, pour engendrer dans ce second corps, des variations de courant proportionnelles aux variations de champ induites par le premier corps, des moyens (10) de mesure de ces variations de courant pour déterminer les variations de champ correspondantes et des moyens de détermination (16) du champ à partir de ces variations.

**2.** Dispositif selon la revendication 1, caractérisé en ce que les moyens de détermination (16) du champ sont reliés à des moyens (11) de génération d'un champ opposé au champ déterminé pour réaliser une réinitialisation du dispositif à la seconde fréquence et permettre une détermination de la valeur absolue du champ.

**3.** Dispositif selon l'une quelconque des revendications précédentes, caractérisé en ce que les premier et second corps (1, 4) sont disposés dans un cryostat (13), à une température inférieure à leur température de transition supraconductrice et en ce qu'il comporte des moyens (7, 8, 14, 15) de chauffage d'au moins une portion de ces corps.

**4.** Dispositif selon la revendication 3, caractérisé en ce que les moyens de chauffage de chaque corps comprennent des moyens de génération d'un rayonnement optique (14, 15).

**5.** Dispositif selon la revendication 4, caractérisé en ce que les moyens de génération du rayonnement optique sont disposés chacun à une extrémité d'un guide optique (7, 8), à l'extérieur du cryostat (13), l'autre extrémité de chaque guide étant disposée en regard du corps (1, 4) correspondant dans le cryostat.

**6.** Dispositif selon la revendication 5, caractérisé en ce que chaque guide optique comporte au moins une fibre optique (7, 8).

**7.** Dispositif selon la revendication 5 ou 6, caractérisé en ce que les moyens de génération du rayonnement optique comprennent chacun une diode laser ou une diode électroluminescente (14, 15).

**8.** Dispositif selon l'une quelconque des revendications précédentes, caractérisé en ce que le premier et le second corps (1, 4) sont disposés l'un au-dessus de l'autre, en ce que le premier corps (1) se présente sous la forme d'un disque et en ce que le second corps (4) se présente sous la forme d'un anneau dont le diamètre est inférieur à celui du disque.

**9.** Dispositif selon les revendications 5, 6 ou 7 et 8, caractérisé en ce que le disque (1) est disposé sur un plot de support (2) d'une embase (3), en regard d'un orifice (6) d'une structure de support (5) de l'anneau (4), le guide optique (8) associé à l'anneau (4) présentant une extrémité en regard d'une portion (4a) de celui-ci et le guide optique (7) associé au disque (1) présentant une extrémité en regard de la partie centrale du disque (1) située face à l'orifice (6) de la structure de support (5).

**10.** Dispositif selon la revendication 9, caractérisé en ce que la surface de la face (9) de la structure de support (5) en regard du disque (1), est réfléchissante.

**11.** Dispositif selon l'une quelconque des revendications précédentes, caractérisé en ce que les moyens de mesure associés au second corps comprennent une bobine (10) formée d'au moins une spire de matériau supraconducteur disposée autour de ce corps.

**12.** Dispositif selon la revendication 11, caractérisé en ce qu'un condensateur est connecté aux bornes de cette bobine pour former un circuit résonnant.

**13.** Dispositif selon la revendication 12, caractérisé en ce que la fréquence de résonance de ce circuit résonnant est égale à la seconde fréquence.

**14.-** Dispositif selon l'une quelconque des revendications 11, 12 ou 13, caractérisé en ce que les moyens de détermination du champ comprennent des moyens (16) de mesure de la tension aux bornes de la bobine (10).

**15.** Dispositif selon l'une quelconque des revendications 2 à 14, caractérisé en ce que les moyens de génération du champ opposé comprennent au moins une bobine de Helmholtz (11) raccordée à des moyens d'alimentation pilotés par les moyens de détermination (16) et dont la tension de sortie est une image de la valeur absolue du champ magnétique à mesurer.

**16.-** Dispositif selon l'une quelconque des revendications précédentes, caractérisé en ce que la première fréquence est de l'ordre de 100 Hz et la seconde de l'ordre de 100 kHz.
